Europäisches Patentamt

European Patent Office

Office européen des brevets

(11) Publication number: **0 500 359 B1**

# EUROPEAN PATENT SPECIFICATION

(45) Date of publication of patent specification: **23.08.95**     (51) Int. Cl.⁶: **C23C 16/00**, C23C 14/08, C23C 16/26

(21) Application number: **92301388.2**

(22) Date of filing: **20.02.92**

(54) Graphite structure carbon or its intercalation compound and process for preparing the same.

(30) Priority: **22.02.91 JP 28204/91**
**28.06.91 JP 158358/91**

(43) Date of publication of application:
**26.08.92 Bulletin 92/35**

(45) Publication of the grant of the patent:
**23.08.95 Bulletin 95/34**

(84) Designated Contracting States:
**DE FR GB**

(56) References cited:
**EP-A- 0 246 037**
**EP-A- 0 251 677**

**PATENT ABSTRACTS OF JAPAN, unexamined applications, C field, vol. 13, no. 417, September 14, 1989 THE PATENT OFFICE JAPANESE GOVERNMENT page 164 C 636**

(73) Proprietor: **SHARP KABUSHIKI KAISHA**
**22-22 Nagaike-cho**
**Abeno-ku**
**Osaka (JP)**

(72) Inventor: **Nakaya, Hiroaki**
**Amenity 508, 129-5,**
**Kawaharajo-cho**
**Tenri-shi,**
**Nara-ken (JP)**
Inventor: **Yoshimoto, Yoshikazu**
**Yabuuchi-haitsu 202,**
**298 Tainosho-cho**
**Tenri-shi,**
**Nara-ken (JP)**
Inventor: **Yoshida, Masaru**
**4-10-10 Seya-higashi,**
**Sango-cho**
**Ikoma-gun,**
**Nara-ken (JP)**
Inventor: **Nakajima, Shigeo**
**603, 2-7-1, Omiya-co**
**Nara-shi,**
**Nara-ken (JP)**

(74) Representative: **West, Alan Harry et al**
**R.G.C. Jenkins & Co.**
**26 Caxton Street**
**London SW1H 0RJ (GB)**

## Description

The present invention relates to a graphite structure carbon or its intercalation compound and a process for preparing the same.

One of the typical conventional process for preparing a graphite structure carbon is a vapor phase pyrolysis process, wherein a material is introduced together with a carrier gas into a reaction chamber in which a substrate is arranged and then the entire reaction chamber or the substrate is heated to form a pyrolytic carbon on the substrate.

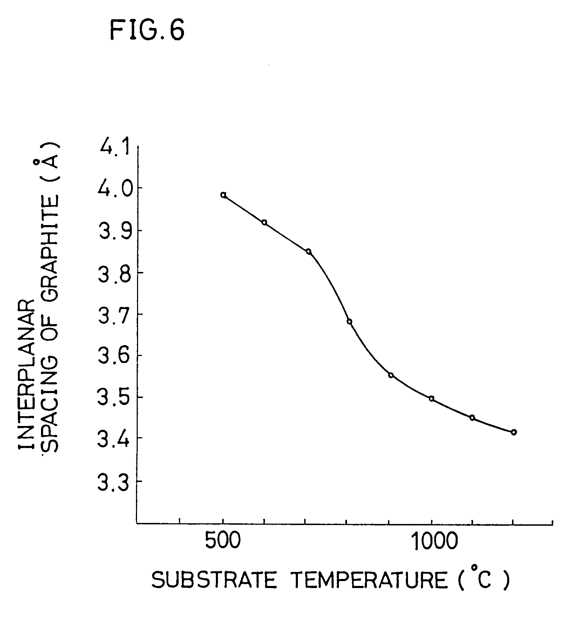

Fig. 6 shows a relationship between the interplanar spacing and the substrate temperature of a graphite structure carbon prepared on a nickel substrate according to a conventional process with propane used as a starting material. This figure shows that the interplanar spacing is 0.385 to 0.40 nm (3.85 to 4.0 Å) at the substrate temperature of 500 to 700 °C, and about 0.35 nm (3.5 Å) at 1000 °C, which teaches that the increased substrate temperature causes the interplanar spacing to be small and that the boundary is present at about 800 °C. In this way, a graphite structure carbon prepared by the vapor phase pyrolysis process generally exhibits excellent crystallinity with the increased substrate temperature. Accordingly, the preparation of a graphite structure carbon having excellent crystallinity and high quality requires a high temperature and a substrate resistant to high temperature. If a high-quality graphite structure carbon can be prepared at low temperature, it would be understood that industrial merits could be obtained.

Our inventors proposed a process for preparing a graphite intercalation compound by pyrolysis of organic compounds of heavy metal such as lead, tin or the like according to the above-mentioned vapor phase pyrolysis process [U.S. Patent No. 4,714,639] and a process for preparing a graphite intercalation compound by pyrolysis of transition metal halides such as titanium (Ti), vanadium (V), chromium (Cr), tungsten (W), molybdenum (Mo), technetium (Tc) or the like according to the above-mentioned vapor phase pyrolysis process [Japanese Laid-Open No. 61(1986)-226808].

However, these vapor phase pyrolysis processes are carried out at the same temperature for pyrolytically decomposing the material of the graphite and for growing the graphite on a substrate, as well as at the same temperature for pyrolytically decomposing the organic metals or transition metal halides and for intercalating the respective metal atoms generated by the pyrolysis. In other words, all of the steps are performed at a single temperature for pyrolytically decomposing the starting gas of the graphite in the conventional preparation.

The methods for preparing a graphite intercalation compound include a solvent method, an electrochemical method, mixing method and a pressure applying method other than the above-mentioned vapor phase pyrolysis process. Further, various intercalants have been reported. The intercalants known so far range over about 300 kinds including (1) alkali metals such as Li, Na, K, Rb, Cs or the like, (2) alkaline earth metals such as Mg, Ca, Sr or the like, (3) halogen gases such as chlorine, bromine or the like, (4) halides such as ICl or the like, (5) metal halides such as $SbCl_5$, $SbF_5$, $AlCl_3$, $FeCl_3$, $CuCl_2$ or the like, (6) acids such as nitric acid, sulfuric acid, $AsF_5$ or the like, (7) intermetallic compounds such as alkali metal-mercury, mercury-bismuth or the like [see Advances in Physics, 30, 139 (1981)].

However, none of the graphite intercalation compounds are sufficient to be used as a thermoelectric converting material.

The present invention provides a process for preparing graphite-structure carbon and intercalation compounds thereof, the process being carried out in a device comprising a decomposition zone A for decomposing a hydrocarbon gas; a product growing zone B where a substrate is disposed; and an optional gas generating zone C for generating gas of an intercalant, by maintaining a temperature in zone B at least more than 50°C lower, preferably more than 100°C lower, than in zone A, and allowing a graphite-structure carbon or an intercalation compound thereof to grow on the substrate.

According to the process of the present invention, a graphite-structure carbon having high crystallinity can be prepared at lower temperature compared to conventional processes.

The process of the present invention makes it possible to prepare a graphite intercalation compound having thermoelectric power of more than 150 $\mu$V/K, for example, a compound having selenium, tellurium, germanium, iron oxides, copper oxides or the like between the graphite layers. Such an intercalation compound is excellent as a thermoelectric converting material.

The present invention is described below in greater detail by way of example only with reference to the accompanying drawings, in which:

Fig. 1 is a schematic view showing a device for preparing a graphite intercalation compound used in the Example of the present invention;

Fig. 2 is a detailed view showing a device for preparing a graphite intercalation compound used in the Example of the present invention;

Fig. 3 is a detailed view showing a device for preparing a graphite intercalation compound used in the Example of the present invention;

Fig. 4 is a schematic view showing a device for measuring thermal conductivity;

Fig. 5 is a view showing a relationship between an interplanar spacing and a substrate temperature of a graphite structure carbon in Example 1; and

Fig. 6 is a view showing a relationship between an interplanar spacing and a substrate temperature of a graphite structure carbon in Comparative Example 1.

The present invention can provide an intercalation compound of a graphite structure carbon having an intercalant of the present invention intercalated between each adjacent or every two graphite layers and having a thermoelectric power of 150 $\mu$V/K or more.

The present invention is accomplished based on the finding of the number of graphite layers between the intercalant layers for minimizing a lattice thermal conductivity (Kph) and the finding that a thermoelectric power ($\alpha$) of the intercalant compound is almost the same as that of the intercalant.

Although the mechanism of this phenomenon is unclear, the present inventors consider as follows.

When an intercalant layer which is a foreign atom layer is intercalated between the graphite layers, a phonon scattering is increased in the direction perpendicular to the layers. This phonon scattering is more increased with the increase of the intercalant layers, showing a maximum value with Kph of 0 when the intercalant layer is intercalated between each adjacent or every two graphite layers.

Further, when a foreign atom layer is intercalated between the graphite layers, an electric charge moves at the interface between the normal intercalant layer and the graphite layer. At this time, the intercalant layer intercalated between the graphite layers is maintained in an ionic state similar to that before intercalation, thus stabilized. On the other hand, the number of carriers in the graphite layer changes with the movement of electric charges. The thermoelectric power $\alpha$ of the graphite layer changes with the number of carriers. However, the thermoelectric power a of the graphite layer is about 13 $\mu$V which is very small, so that the change in the number of carriers is also very small. Consequently, the change in the thermoelectric power $\alpha$ of the graphite matrix is negligible even if the number of carriers changes with the movement of electric charges. Therefore, the graphite matrix is considered to be a structure for only positioning the intercalant, thereby giving no influence on the thermoelectric power $\alpha$. On the other hand, the thermoelectric power of the intercalant layer shows almost the same value as that of the graphite structure carbon before intercalation since the intercalant layer per se is in a condition similar to the graphite structure carbon before intercalation.

As a result, the thermoelectric power $\alpha$ of the intercalation compound becomes approximately the same value as that of the intercalant.

A conventional device can be basically used for the process of the present invention. However, a decomposing device having provided therein both the decomposing area A for hydrocarbon compound gas and the product growing area B where the substrate is mounted requires a structure for independently controlling the temperature of the respective areas to a predetermined temperature.

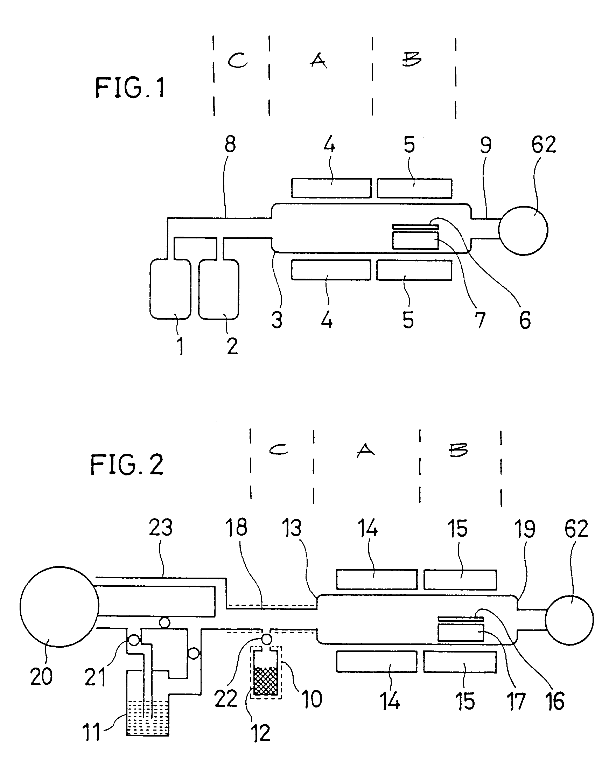

The basic structure of the device used for the present invention will be explained hereinbelow with reference to Fig. 1.

The device shown in Fig. 1 comprises a graphite material container 1 accommodating therein aliphatic hydrocarbon, aromatic hydrocarbon, alicyclic hydrocarbon or the like, an intercalant material container 2 accommodating therein an intercalant material for serving as a supply source thereof, a reaction tube 3 and a material transfer tube 8 for transferring the material gas to the reaction tube 3. The gas from the graphite material container 1 is mixed with the gas from the intercalant material container 2 in the transfer tube 8, so that the resultant mixture is supplied to the reaction tube 3. A high-temperature furnace 4 and a low-temperature furnace 5 heat a high-temperature chamber and a low-temperature chamber of the reaction tube 3. The high-temperature furnace 4 pyrolytically decomposes the material gas such as the aliphatic hydrocarbon, aromatic hydrocarbon, alicyclic hydrocarbon or the like introduced from the graphite material container 1 to the high-temperature chamber of the reaction tube 3.

The material gas transferred to the low-temperature chamber grows as graphite on a substrate 6 placed on a substrate support 7. The intercalant gas simultaneously transferred thereto is intercalated between the graphite layers during the growing process of the graphite. The remaining vapor led to the reaction tube 3 is discharged outside through a discharge pipe 9.

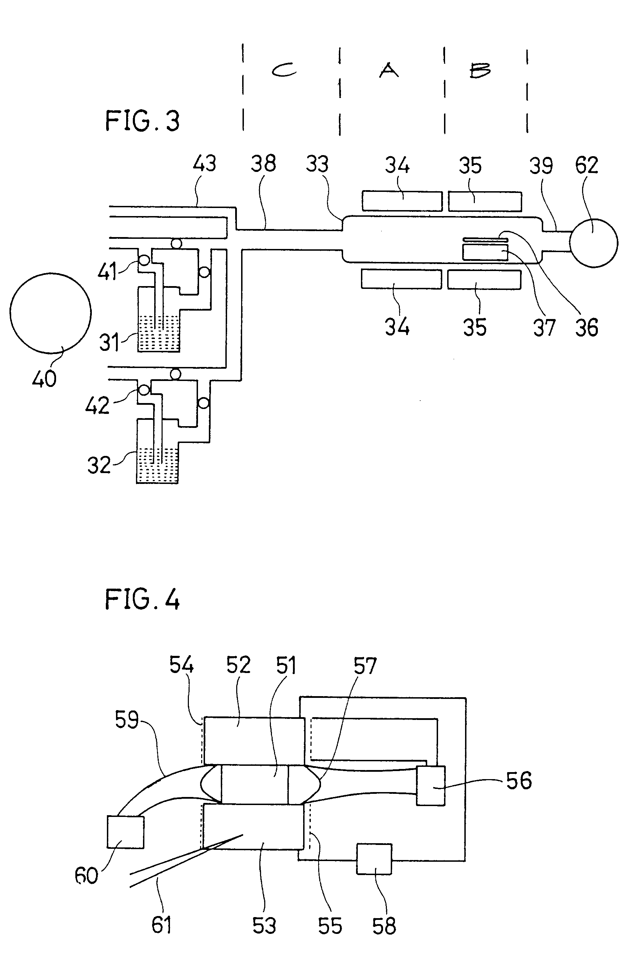

The devices shown in Figs. 2 and 3, which are the modifications of the device shown in Fig. 1, will be explained in detail in the embodiments stated later.

The devices shown in Figs. 1 to 3 have, in a single furnace, both the high-temperature furnace corresponding to the decomposition area A for hydrocarbon compound gas and the low-temperature furnace corresponding to the product growing area B. However, the high-temperature furnace and low-

EP 0 500 359 B1

temperature furnace can be independently provided, both of which are connected to each other by a pipe used for transferring vapor phase.

The gas generating area C is provided at the same portion as the decomposition area A in each of the devices shown in Figs. 1 to 3. However, the low-temperature furnace may be directly connected to the intercalant material container to be served as the gas generating area C. Further, the gas generating area C can be independently provided.

A hydrocarbon compound gas is used as a main material for preparing the graphite structure carbon or its intercalation compound of the present invention.

Usable hydrocarbon compound is the one which easily becomes gaseous and is decomposed to generate carbon. Various hydrocarbon compounds known in the field of this art can be used.

Examples of the hydrocarbon compounds include an aliphatic hydrocarbon, aromatic hydrocarbon and heterocyclic hydrocarbon, which may have substituents such as a halogen atom, hydroxyl group, sulfonic acid group, nitro group, nitroso group, amino group, carboxyl group or the like.

Specifically, examples of the hydrocarbon compounds are saturated aliphatic hydrocarbon such as methane, ethane, propane, butane, pentane, hexane, cyclohexane or the like, unsaturated aromatic hydrocarbon such as ethylene, dichloroethylene, dibromoethylene, 2-butyne, acetylene, diphenylacetylene or the like, aromatic hydrocarbon such as naphthalene, anthracene, pyrene, benzene, toluene, allylbenzene, hexamethylbenzene, aniline, phenol, styrene, biphenyl or the like and heterocyclic compound such as pyridine, pyrrole, thiophene or the like.

The use of dichloroethylene or acetylene decreases the temperature for heating the substrate.

The intercalants used for preparing the graphite intercalation compound of the present invention are not specifically limited which can form the intercalation compound. The process of the present invention can prepare an intercalation compound having Se or Te intercalated between the graphite layers. Such a compound could not be obtained according to the conventional process.

Preferable materials for generating the intercalant gas used for the present invention are listed below.

(a) metals such as Se, Te, Si, Bi or Ge and their oxides (e.g., $SeO_2$, $TeO_2$, $SiO_2$, $BiO_2$, $Bi_2O_3$, $GeO$, $GeO_2$ or the like); halides (e.g., $SeCl_4$, $SeBr_4$, $SeI_4$, $TeCl_4$, $TeBr_4$, $TeI_4$, $SiCl_4$, $SiBr_4$, $BiCl_4$, $BiBr_4$, $BiI_4$, $GeCl_4$, $GeBr_4$, $GeI_4$ or the like); organic compounds (e.g., $(C_6H_5)_2Se_2$, $(C_6H_5)SeCl$, Methylbenzselenazol $(C_8H_7NSe)$, $C_6H_5SeH$, $SeC(NH_2)_2$, $Si(OCH_3)_4$, $Si(OC_2H_5)_4$, $SiH_4$, $(C_6H_5)_3SiH$, $(C_6H_5)_3SiCl$, $(CH_3)_3SiCl$, $(CH_3)SiBr$, $(C_2H_5)_3SiCl$, $(CH_3)_4Si$, $Si_2H_6$, $(C_6H_5)_3Bi$, $GH_4$ or the like);

(b) Fe or Cu or its oxides (e.g., $FeO$, $Fe_3O_4$, $Fe_2O_3$, $CuO$, $Cu_2O$ or the like; materials for forming Fe or Cu or its oxides by pyrolysis.

In the process of the present invention, a temperature at the decomposition area A is set different from that at the product growing area B. Specifically, the temperature at the area B is set lower than that at the area A by at least more than 50 °C, preferably more than 100 °C.

The temperature at the respective areas A and B are set depending upon the type of the hydrocarbon compound gas and the material for the intercalant gas.

When a graphite structure carbon is prepared, the area A is generally set to a temperature within the range of about 850 to 1300 °C, while the area B is generally set to a temperature within the range of 600 to 1100 °C, preferably 400 to 750 °C.

When an intercalation compound is prepared, the area A is generally set to a temperature within the range of about 300 to 1600 °C, preferably 400 to 1500 °C, while the area B is generally set to a temperature within the range of 300 to 1100 °C, preferably 350 to 1000 °C.

The above-mentioned temperature at the area A is suitable for decomposing the hydrocarbon compound gas and at the same time for generating the intercalant gas (at the area C). In the case where the intercalant gas generated in the area C which is independently provided is directly introduced to the area B, the temperature at the area C is determined depending upon the type of the material for the intercalant. In such a case, the area B is set to a temperature lower than that at the area C by at least 50 °C.

The supply amount of the intercalant material is preferably set to about 0.06 to 3.0 mols, more preferably 0.08 to 1.5 mols, to 1 mol of that of the hydrocarbon compound. When the supply amount of the intercalant material departs from the above conditions, the intercalant cannot be intercalated, or the intercalant layer is intercalated between every three or more layers, or the precipitate of the intercalant occurs with time due to an excessive intercalation, whereby it is difficult to form the graphite intercalation compound having the intercalants in a suitable amount.

For example, the intercalant material is preferably supplied under the following conditions:

4

| | |
|---|---|
| Supply rate: | 0.04 to 2.3 mol/hr. |
| Molecular density: | $1.6 \times 10^{20}$ to $4.0 \times 10^{22}$ molecules/l |
| Flow rate: | 0.5 to 70 cm/min. |

in the case where the hydrocarbon compound serving as a graphite material is supplied under the following conditions:

| | |
|---|---|
| Supply rate: | 0.05 to 1.5 mol/hr. |
| Molecular density: | $2 \times 10^{21}$ to $2.6 \times 10^{22}$ molecules/l |
| Flow rate: | 0.5 to 70 cm/min. |

It is possible to prepare a graphite intercalation compound which is controlled to have how many graphite layers are present between the intercalant layers by controlling the supply amount of both the intercalant material and the hydrocarbon compound.

Further, a graphite intercalation compound having high thermoelectric power can be prepared by intercalating the intercalant having thermoelectric power of more than 150 $\mu$V/K between each adjacent or every two graphite layers. Examples of the intercalants having thermoelectric power of more than 150 $\mu$V/K are Se, Te, Bi, Ge or Si, or its oxide, an oxide of Fe or an oxide of Cu.

Examples of the substrate for preparing the graphite intercalation compound are inorganic compounds such as quartz, sapphire, alumina, SiC, Si or the like, or metals such as copper, platinum, nickel, iron or the like. The substrate formed of a metal is especially preferable since it can be used per se as a conductor due to conductivity of the metal. Particularly, the substrate formed of an iron element (iron, cobalt or nickel) or a metal alloy including the same has an effect for accelerating catalysis of the various hydrocarbon compounds to the pyrolysis reaction and carbonization of the carbon, thus preferable.

The present invention will be explained in details with reference to the following examples, by which the present invention shall not be limited.

In the following examples, the composition and structure of the resultant deposit were evaluated by an X-ray image and X-ray diffraction peak of the intercalants obtained with an electron microscope. The electrical conductivity, thermal conductivity and thermoelectric power were measured by DC four-terminal method, optical AC method using a commercially available device and a method using the device shown in Fig. 4, respectively.

Example 1 and Comparative Example 1

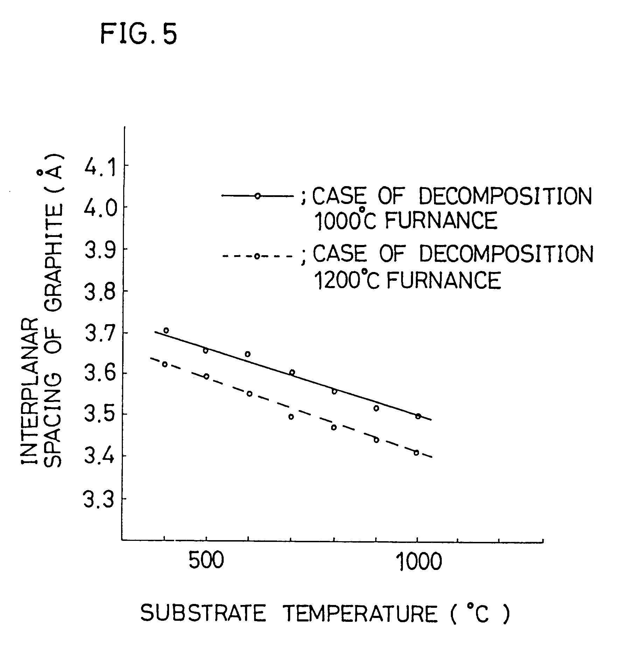

Graphite structure carbons were prepared by using a device shown in Fig. 1. Propane was used as a material gas, while a substrate was formed of nickel. The parameters for the preparation were shown in Table 1. Figs. 5 and 6 each shows a relationship between the interplanar spacing and the substrate temperature of the graphite structure carbons obtained in Example 1 and Comparative Example 1 respectively. These figures teach that the carbon film deposited on the substrate at the same temperature obtained in Example 1 was proved to have excellent crystallinity compared to Comparative Example 1. Especially, the priority of the resultant product obtained in Example 1 is remarkable at the substrate temperature range of 500 to 700 °C. Specifically, the interplanar spacing of the product obtained in Comparative Example 1 is about 0.385 to 0.40 nm (3.85 to 4.0 Å) at 1000 °C, and 0.35 to 0.36 nm (3.5 to 3.6 Å) at 1200 °C.

Examples 2 and 3 and Comparative Examples 2 and 3

Graphite structure carbons were prepared by using a device shown in Fig. 1. Benzene or propane was used as a material gas, while a substrate was formed of nickel. The parameters for the preparation were shown in Table 2. Table 3 shows a relationship between the interplanar spacing and the substrate temperature of the obtained graphite structure carbons. This table teaches that the carbon film deposited on the substrate at the same temperature obtained in Examples 2 and 3 were proved to have excellent crystallinity compared to Comparative Examples 2 and 3. Especially, the priority of the resultant products obtained in Examples 2 and 3 is remarkable at the substrate temperature range of 500 to 700 °C. Further, it is observed from Table 3 that propane improves crystallinity more than benzene.

Example 4

A process for intercalating tellurium which serves as an intercalation compound by using benzene which serves as a hydrocarbon compound of the graphite material will be explained with reference to Fig. 2 which shows the schematic view of Fig. 1 in more detail.

Argon gas is supplied from an argon gas controller 20 to the inside of a bubble container 11 accommodating therein benzene purified through vacuum distillation, thereby bubbling benzene to lead the benzene molecules to a quartz reaction tube 13 through a transfer tube 18. The amount of the benzene molecules to be supplied to the quartz reaction tube 13 are controlled by keeping constant the temperature of the liquid benzene in the bubble container 11 as well as by adjusting the flow rate of argon gas with a first valve 21. Tellurium atoms are supplied from a container 12 to the transfer tube 18, resulting in that the benzene molecules are mixed with the tellurium atoms in the transfer tube 18 so as to be simultaneously supplied to the reaction tube 13 together therewith. The container 12 and the transfer tube 18 are covered with a heating tape 10. When the inside of the container 12 is heated to a predetermined temperature, tellurium accommodated therein is evaporated. The tellurium vapor is then transferred to the reaction tube 13 at constant speed with the adjustment of a second valve 22. On the other hand, argon gas is fed from a diluted line 23 to optimize the molecular density and flow rate of the benzene molecules and tellurium atoms in the argon gas supplied to the quartz reaction tube 13. The reaction tube 13 is inserted into a heating furnace which comprises a high-temperature furnace 14 and a low-temperature furnace 15 for heating the reaction tube 13 to a respective reaction temperature. Therefore, a high-temperature chamber and low-temperature chamber are present in the reaction tube 13. A support 17 having placed thereon a substrate 16 for growing a graphite intercalation compound is arranged in the low-temperature chamber of the reaction tube 13. The benzene molecules led into the reaction tube 13 are pyrolytically decomposed by the high-temperature furnace 14, whereby graphite or carbon deposit is growingly formed on the substrate which is arranged in the low-temperature chamber. The tellurium atoms simultaneously led to the reaction tube 13 are intercalated between the graphite layers during the growing process, thereby obtaining a graphite intercalation compound having the tellurium atoms intercalated between the graphite layers. The remaining vapor led to the reaction tube 13 is discharged outside through a discharge pipe 19.

A graphite intercalation compound having tellurium atoms intercalated between the graphite layers was obtained by performing the above-mentioned process with the following conditions:

| Substrate 16: | Nickel |
| Temp. of the high-temperature furnace 14: | 1000°C |
| Temp. of the low-temperature furnace 15 : | 750°C |
| Temp. for evaporating tellurium: | 500°C |
| Supply rate of benzene: | 0.50 mol/hr. |
| Supply rate of tellurium: | 0.38 mol/hr. |

A suitable supply rate ratio of benzene to tellurium for preparing a graphite intercalation compound having a tellurium layer intercalated between each adjacent graphite layers varies depending upon the kind of hydrocarbon compound used as a starting material. When benzene is used as a hydrocarbon compound, the effective supply amount of benzene is within the range of 0.6 to 2.5 mols to 1 mol of that of tellurium at 1000 °C of the high-temperature furnace 14. The change in the amount of tellurium led to the reaction tube 13 causes the molecular density of tellurium atoms to be changed, which makes it possible to control how many graphite layers are present adjacent to the tellurium layer. The effective supply amount of benzene for preparing a graphite intercalation compound having a tellurium layer between every two graphite layers is within the range of 2.5 to 5.0 mols to 1 mol of that of tellurium. It is possible to intercalate the tellurium layer between every three or four graphite layers by increasing the ratio of benzene. However, the benzene amount less than 0.6 mol causes precipitates of tellurium with time due to the excessive intercalation of tellurium.

The X-ray image in the graphite film taken with an electron microscope proved that the tellurium atoms were uniformly present between the graphite layers. Further, the reflection corresponding to the sum of the radius of the tellurium atom and the thickness of the graphite layer between the tellurium layers can be observed from the X-ray diffraction. The intercalation compound thus obtained was confirmed by the same manner as described above to have the staging structure unchanged even if left in the air at high temperature.

The thermoelectric power ($\alpha$) of the obtained graphite intercalation compound having the tellurium layer intercalated between the graphite layers was 800 $\mu VK^{-1}$ in the direction perpendicular to the layers. This value is remarkably greater than the value of 40 $\mu VK^{-1}$ which is the maximum value of a conventional graphite intercalation compound obtained by intercalating an antimony pentachloride ($SbCl_5$) molecules between the graphite layers, and is further more than 250 $\mu VK^{-1}$ of a conventional thermoelectric material such as $Bi_2Te_3$ or the like. The electrical conductivity $\sigma$ and thermal conductivity ($x$) of the obtained graphite intercalation compound were 1200 $\Omega^{-1}cm^{-1}$ and $6.0 \times 10^{-3}$ $Wcm^{-1}K^{-1}$ respectively. The ratio of $\alpha/x$ was more than four times as large as that of the conventional thermoelectric material such as $Bi_2Te_3$ or the like. The thermoelectric power a was determined by the following manner. First, a temperature difference T is varied from 0.2 to 0.6 °C for measuring the thermoelectromotive force $\Delta$ EMF corresponding to the respective temperature difference by using a device shown in Fig. 4. Each of the thermoelectric power $\alpha$ at the respective temperature difference was calculated from the equation of $\alpha = \Delta EMF/ \Delta T$, from which the mean value was obtained.

The same result as described above was obtained when the other hydrocarbon compound such as propane or the like was used as a graphite material in the above process. When a hydrocarbon compound having a molecular amount of 100 or below is employed, a suitable supply amount of hydrocarbon compound for preparing a graphite intercalation compound having a tellurium layer between each adjacent graphite layers is preferably about 0.4 to 8 mols, more preferably about 0.5 to 6 mols, to 1 mol of tellurium under the following conditions:

| Temperature at high-temperature furnace: | 900 to 1600 °C (preferably 1000 to 1500 °C) |
|---|---|
| Temperature at low-temperature furnace: | 550 to 900 °C (preferably 800 to 900 °C) |

The effective supply amount of hydrocarbon compound suitable for preparing a graphite intercalation compound having the tellurium layer between every two graphite layers is 6.0 to 12.0 mols to 1 mol of tellurium.

This process can employ other inert gas such as nitrogen, helium or the like instead of argon gas. HCl gas can be used for transferring tellurium.

Example 5

The result same as Example 4 was obtained by the process of Example 4 except for using an organic metal or a halide of tellurium as an intercalant material instead of telluriun. Specifically, in this process, the intercalant material of the organic metal or the halide is introduced together with benzene to the reaction tube, and then the tellurium intercalants obtained by pyrolysis are transferred to the low-temperature chamber. The process utilizing diethyl tellurium ($Te(C_2H_5)_2$) as an intercalant material will be explained with reference to Fig. 3 which shows the schematic view of Fig. 1 in more detail.

Argon gas is supplied from an argon gas controller 40 to the inside of a first bubble container 31 accommodating therein benzene purified through vacuum distillation and to the inside of a second bubble container 32 accommodating therein diethyl tellurium purified through vacuum distillation, thereby bubbling benzene and diethyl tellurium to lead the benzene and diethyl tellurium molecules to a quartz reaction tube 33 through a transfer tube 38. The amounts of the benzene and diethyl tellurium molecules to be supplied to the quartz reaction tube 33 are independently controlled by keeping constant the temperature of the liquid benzene in the first bubble container 31 and the temperature of diethyl tellurium in the second bubble container 32 as well as by adjusting the flow rate of argon gas with first and second valves 41 and 42. On the other hand, argon gas is fed from a diluted line 43 to optimize the molecular density and flow rate of the benzene molecules and diethyl tellurium atoms in the argon gas supplied to the quartz reaction tube 33.

A graphite intercalation compound having tellurium atoms intercalated between the graphite layers was obtained by performing the above-mentioned process with the following conditions:

| Substrate 36: | Nickel |
|---|---|
| Temp. of the high-temperature furnace 34: | 1100 °C |
| Temp. of the low-temperature furnace 35: | 800 °C |
| Supply rate of benzene: | 0.30 mol/hr. |
| Supply rate of diethyl tellurium: | 0.20 mol/hr. |

A suitable supply rate ratio of hydrocarbon compound to diethyl tellurium for preparing a graphite intercalation compound having a tellurium layer intercalated between each adjacent graphite layers varies depending upon the kind of hydrocarbon compound used as a starting material. When benzene is used as a hydrocarbon compound, the effective supply amount of benzene is within the range of 0.5 to 2.0 mols to 1 mol of that of diethyl tellurium at 1100 °C of the high-temperature furnace 34. The change in the amount of diethyl tellurium led to the reaction tube 33 causes the molecular density of the pyrolytically-produced tellurium atoms to be changed, which makes it possible to control how many graphite layers are present adjacent to the tellurium layer. The effective supply amount of benzene for preparing a graphite intercalation compound having a tellurium layer between every two graphite layers is within the range of 1.6 to 3.2 mols to 1 mol of that of diethyl tellurium. It is possible to intercalate the tellurium layer between every three or four graphite layers by increasing the ratio of benzene. However, the benzene amount less than 0.5 mol causes precipitates of tellurium with time due to the excessive intercalation of tellurium.

The obtained deposit was evaluated by the same manner as in Example 4, obtaining the properties same as that of Example 4.

The same result as described above was obtained when the other hydrocarbon compound such as propane or the like was used as a graphite material in the above process. When a hydrocarbon compound having a molecular amount of 100 or below is employed, a suitable supply amount of hydrocarbon compound for preparing a graphite intercalation compound having a tellurium layer between each adjacent graphite layers is preferably about 0.5 to 5 mols to 1 mol of that of diethyl tellurium under the following conditions:

| Temperature at high-temperature furnace: | 900 to 1600 °C (preferably 1000 to 1500 °C) |
| Temperature at low-temperature furnace: | 550 to 900 °C (preferably 800 to 900 °C) |

The effective supply amount of hydrocarbon compound suitable for preparing a graphite intercalation compound having the tellurium layer between every two graphite layers is 5.0 to 12.0 mols to 1 mol of that of diethyl tellurium. Similar to Example 3, the tellurium intercalant was accurately intercalated in the greatest amount at 850 °C of the low-temperature furnace.

The same result was obtained when tellurium hydride ($TeH_2$) was used as the intercalant material in this process instead of diethyl tellurium.

Example 6

A graphite intercalation compound having selenium atoms intercalated between the graphite layers was prepared by the same manner as in Example 4 by using the device shown in Fig. 2 under the following conditions:

| Hydrocarbon compound of Graphite Material: | Benzene |
| Intercalant Material: | Selenium |
| Substrate: | Nickel |
| Temp. of the high-temperature furnace : | 900 °C |
| Temp. of the low-temperature furnace : | 550 °C |
| Temp. for evaporating selenium: | 400 °C |
| Supply rate of benzene: | 0.65 mol/hr. |
| Supply rate of selenium: | 0.70 mol/hr. |

A suitable supply rate ratio of benzene to selenium for preparing a graphite intercalation compound having a selenium layer intercalated between each adjacent graphite layers varies depending upon the kind of hydrocarbon compound used as a starting material. When benzene is used as a hydrocarbon compound, the effective supply amount of benzene is within the range of 1.2 to 2.4 mols to 1 mol of that of selenium at 900 °C of the high-temperature furnace. The effective supply amount of benzene for preparing a graphite intercalation compound having a selenium layer between every two graphite layers is within the range of 2.4 to 4.8 mols to 1 mol of that of selenium. It is possible to intercalate the selenium layer between every three or four graphite layers by increasing the ratio of benzene. However, the benzene amount less than 1.2 mol causes precipitates of selenium with time due to the excessive intercalation of selenium.

The same result as described above was obtained when the other hydrocarbon compound such as propane or the like was used as a graphite material in the above process. When a hydrocarbon compound having a molecular amount of 100 or below is used, a suitable supply amount of hydrocarbon compound for preparing a graphite intercalation compound having a selenium layer between each adjacent graphite layers is preferably about 0.6 to 4 mols to 1 mol of that of selenium under the following conditions:

| Temperature at high-temperature furnace: | 900 to 1600 °C (preferably 900 to 1200 °C) |
| Temperature at low-temperature furnace: | 400 to 700 °C (preferably 450 to 550 °C) |

The effective supply amount of hydrocarbon compound suitable for preparing a graphite intercalation compound having the selenium layer between every two graphite layers is 4.0 to 12.0 mols to 1 mol of selenium.

This process can employ other inert gas such as nitrogen, helium or the like instead of argon gas.

The X-ray image in the graphite film taken with an electron microscope proved that the selenium atoms were uniformly present between the graphite layers. Further, the reflection corresponding to the sum of the radium of the selenium atom and the thickness of the graphite layer between the selenium layers can be observed from the X-ray diffraction. The intercalation compound thus obtained was confirmed by the same manner as described above to have the staging structure unchanged even if left in the air at high temperature.

The thermoelectric power ($\alpha$) of the obtained graphite intercalation compound having the selenium layer intercalated between the graphite layers was 900 $\mu VK^{-1}$ in the direction perpendicular to the layers. This value is remarkably greater than the value of 40 $\mu VK^{-1}$ which is the maximum value of a conventional graphite intercalation compound obtained by intercalating an antimony pentachloride ($SbCl_5$) molecules between the graphite layers, and is further more than 250 $\mu VK^{-1}$ of a conventional thermoelectric material such as $Bi_2Te_3$ or the like. The electrical conductivity $\sigma$ and thermal conductivity ($x$) of the obtained graphite intercalation compound were 1100 $\Omega^{-1}cm^{-1}$ and 5.5 x $10^{-3}$ $Wcm^{-1}K^{-1}$ respectively. The ratio of $\sigma/x$ was more than four times as large as that of the conventional thermoelectric material such as $Bi_2Te_3$ or the like.

The same result was obtained by the process of Example 6 except for using an organic metal of selenium such as diphenyl diselenide (($C_6H_5)_2Se_2$), phenyl selenyl chloride (($C_6H_5$)SeCl), methyl benzselenazol ($C_8H_7NSe$), selenophenol ($C_6H_5SeH$), selenourea ($SeC(NH_2)_2$) as an intercalant material instead of selenium. Specifically, in this process, the intercalant material of the organic metal of selenium is introduced together with hydrocarbon compound such as benzene or propane to the reaction tube, and then the selenium intercalants obtained by pyrolysis at the high-temperature furnace are transferred to the low-temperature chamber. When a hydrocarbon compound having a molecular amount of 100 or below is used, a supply amount of hydrocarbon compound is preferably about 0.6 to 10 mols, and more preferably about 0.9 to 7 mols, to 1 mol of the intercalant material under the following conditions:

| Temperature at high-temperature furnace: | 900 to 1600 °C (preferably 900 to 1200 °C) |
| Temperature at low-temperature furnace: | 400 to 700 °C (preferably 450 to 550 °C) |

Example 7

A graphite intercalation compound was obtained by the same manner as in Examples 4 and 6 with the use of the device shown in Fig. 2. Specifically, benzene was used as a hydrocarbon compound of a graphite material, while bismuth fluoride, selenium oxide or tellurium dioxide was employed as an intercalant material which was intercalated per se between the graphite layers without performing pyrolysis by the high-temperature furnace.

Table 3 shows examples of parameters in the above process such as temperature for evaporating the intercalant material, temperature of the high-temperature furnace, temperature of the low-temperature furnace, supply rate of each gas or the like.

The same result was obtained when other hydrocarbon compounds such as propane or the like were used as a graphite material. When a hydrocarbon compound having a molecular amount of 100 or below is used, a supply amount of hydrocarbon compound is preferably about 0.6 to 10 mols, and more preferably about 0.7 to 6 mols, to 1 mol of that of the intercalant material under the following conditions:

| Temperature at high-temperature furnace: | 750 to 1400 °C (preferably 750 to 1100 °C) |
| Temperature at low-temperature furnace: | 400 to 800 °C (preferably 550 to 800 °C) |

## Example 8

The device shown in Fig. 2 which was used for the process of Examples 4, 6 and 7 for intercalating between the graphite layers an intercalant having a low boiling point and low decomposition temperature, such as germanium tetrachloride, silicon tetrachloride, tellurium tetrachloride, bismuth tribromide, cupric bromide, ferrous bromide, ferric bromide, germanium tetrabromide, selenium tetrabromide, silicon tetrabromide, bismuth triiodide, germanium tetraiodide, selenium tetraiodide or the like. Specifically, the low-temperature furnace 15 around the low-temperature chamber of the reaction tube 13 for heating the support 17 was removed. The support 17 was directly heated by resistance heat for controlling the temperature of the substrate 16. The intercalant material was transferred directly to the substrate in the low-temperature chamber of the reaction tube without passing through the high-temperature chamber of the reaction tube. Dichloroethylene which was easy to be pyrolytically decomposed was used as a hydrocarbon compound of a graphite material, a nickel was used as a substrate and germanium tetrachloride, silicon tetrachloride, tellurium tetrachloride, bismuth tribromide, germanium tetrabromide, selenium tetrabromide, silicon tetrabromide, bismuth triiodide, germanium tetraiodide and selenium tetraiodide were used as an intercalant material. The vapor of these intercalant materials were intercalated per se between the graphite layers without decomposition. Table 4 shows examples of parameters in the above process such as temperature for evaporating the intercalant material, temperature of the high-temperature furnace, temperature of the low-temperature furnace, supply rate of each gas or the like.

A supply amount of dichloroethylene is preferably about 1.2 to 16 mols, and more preferably about 1.5 to 12 mols, to 1 mol of that of the intercalant material under the following conditions:

| Temperature at high-temperature furnace: | 300 to 800 °C (preferably 400 to 800 °C) |
| Temperature at low-temperature furnace: | 200 to 600 °C (preferably 300 to 550 °C) |

The same result was obtained when acetylene was used as a graphite material instead of dichloroethylene.

## Example 9

The device shown in Fig. 2 which was used for the process of Examples 4, 6 and 7 for intercalating between the graphite layers an intercalant having a high boiling point and easy to form carbide at high vapor pressure in the presence of carbon atoms, such as iron, copper, germanium, bismuth, silicon, bismuth oxide, cuprous oxide, copper oxide, iron oxide, tri-iron tetroxide, ferric oxide, germanium oxide, germanium dioxide, silicon oxide or the like. Specifically, the low-temperature furnace 15 around the low-temperature chamber of the reaction tube 13 for heating the support 17 was removed. The support 17 was directly heated by resistance heat for controlling the temperature of the substrate 16. The intercalant material was transferred directly to the substrate in the low-temperature chamber of the reaction tube without passing through the high-temperature chamber of the reaction tube. A radiofrequency induction heating process capable of heating to 2500 °C was employed to heat for evaporating the intercalant materials. By this process, the above-mentioned intercalant materials could be intercalated between the graphite layers on the substrate in the low-temperature chamber without forming a carbide by the reaction at high temperature between the gas of the graphite material pyrolytically decomposed in the high-temperature chamber of the reaction tube 13 and the intercalant materials. Table 5 shows examples of parameters in the above process such as temperature for evaporating the intercalant material, temperature of the high-temperature furnace, temperature of the low-temperature furnace, supply rate of each gas or the like.

The same result was obtained when the other hydrocarbon compounds such as propane or the like were used as a graphite material. A supply amount of hydrocarbon compound is preferably about 0.5 to 6 mols, and more preferably about 0.5 to 3 mols, to 1 mol of the intercalant material under the following conditions:

| Temperature at high-temperature furnace: | 900 to 1600 °C (preferably 1000 to 1500 °C) |
| Temperature at low-temperature furnace: | 700 to 900 °C (preferably 800 to 900 °C) |

Example 10

The result same as Example 9 was obtained by the process of Example 9 except for using an organic metal of germanium, bismuth or silicon or a halide thereof as an intercalant material instead of the intercalant used in the process of Example 8. Specifically, in this process, the intercalant material of the organic metal or the halide of germanium, bismuth or silicon is introduced together with benzene to the reaction tube, and then the intercalants of germanium, bismuth or silicon atom obtained by pyrolysis are transferred to the low-temperature chamber. The process utilizing benzene as a hydrocarbon compound of a graphite material and triphenyl bismuth $((C_6H_5)_3Bi)$ as an intercalant material will be explained with reference to Fig. 2.

Argon gas is supplied from the argon gas controller 20 to the inside of the bubble container 11 accommodating therein benzene purified through vacuum distillation, thereby bubbling benzene to lead the benzene molecules to the quartz reaction tube 13 through the transfer tube 18. The amount of the benzene molecules to be supplied to the quartz reaction tube 13 are controlled by keeping constant the temperature of the liquid benzene in the bubble container 11 as well as by adjusting the flow rate of argon gas with the first valve 21. Triphenyl bismuth atoms are supplied from the container 12 to the transfer tube 18, resulting in that the benzene molecules are mixed with the triphenyl bismuth atoms in the transfer tube 18 so as to be simultaneously supplied to the reaction tube 13 together therewith. The container 12 and the transfer tube 18 are covered with a heating tape. When the inside of the container 12 is heated to a predetermined temperature, triphenyl bismuth accommodated therein is evaporated. The triphenyl bismuth vapor is then transferred to the reaction tube 13 at constant speed with the adjustment of the second valve 22. On the other hand, argon gas is fed from the diluted line 23 to optimize the density and flow rate of the benzene molecules and triphenyl bismuth molecules in the argon gas supplied to the quartz reaction tube 13. The reaction tube 13 is inserted into the heating furnace which comprises the high-temperature furnace 14 and the low-temperature furnace 15 for heating the reaction tube 13 to a respective reaction temperature. Therefore, the high-temperature chamber and low-temperature chamber are present in the reaction tube 13. The support 17 having placed thereon the substrate 16 for growing a graphite intercalation compound is arranged in the low-temperature chamber of the reaction tube 13. The benzene molecules led into the reaction tube 13 are pyrolytically decomposed by the high-temperature furnace 14. At this time, triphenyl bismuth is simultaneously decomposed in the high-temperature chamber for transferring the bismuth atoms to the low-temperature chamber, whereby the bismuth atoms are intercalated between the graphite layers during the growing process of the graphite deposit on the substrate, thereby obtaining a graphite intercalation compound having the bismuth atoms intercalated between the graphite layers.

A graphite intercalation compound having bismuth atoms intercalated between the graphite layers was obtained by performing the above-mentioned process with the following conditions:

| Substrate 16: | Nickel |
| Temp. of the high-temperature furnace 14: | 1150 °C |
| Temp. of the low-temperature furnace: | 850 °C |
| Temp. for evaporating triphenyl bismuth: | 100 °C |
| Supply rate of benzene: | 1.0 mol/hr. |
| Supply rate of triphenyl bismuth: | 0.9 mol/hr. |

The X-ray image in the graphite film taken with an electron microscope proved that the bismuth atoms were uniformly present between the graphite layers. Further, the reflection corresponding to the sum of the radium of the bismuth atom and the thickness of the graphite layer between the bismuth layers can be observed from the X-ray diffraction.

A suitable supply rate ratio of hydrocarbon compound to triphenyl bismuth for preparing a graphite intercalation compound having a bismuth layer intercalated between each adjacent graphite layers varies depending upon the kind of hydrocarbon compound used as a starting material. When benzene is used as a hydrocarbon compound, the effective supply amount of benzene is within the range of 0.5 to 1.0 mol to 1 mol of that of triphenyl bismuth at 1150 °C of the high-temperature furnace 15. The change in the amount of triphenyl bismuth led to the reaction tube 13 causes the molecular density of bismuth atoms to be changed, which makes it possible to control how many graphite layers are present adjacent to the bismuth layer. The effective supply amount of benzene for preparing a graphite intercalation compound having a bismuth layer between every two graphite layers is within the range of 1.0 to 2.5 mols to 1 mol of that of triphenyl bismuth. It is possible to intercalate the bismuth layer between every three or four graphite layers by increasing the ratio of benzene. However, the benzene amount less than 1.0 mol causes precipitates of bismuth with time due to the excessive intercalation of bismuth.

The thermoelectric power ($\alpha$) of the obtained graphite intercalation compound having the bismuth layer intercalated between the graphite layers was 150 $\mu VK^{-1}$ in the direction perpendicular to the layers. This value is remarkably greater than the value of 40 $\mu VK^{-1}$ which is the maximum value of a conventional graphite intercalation compound obtained by intercalating an antimony pentachloride ($SbCl_5$) molecules between the graphite layers. The conductivity $\sigma$ and thermal conductivity ($x$) of the obtained graphite intercalation compound were 1900 $\Omega^{-1}cm^{-1}$ and $1.1 \times 10^{-2}$ $Wcm^{-1}K^{-1}$ respectively. The ratio of $\sigma/x$ was more than four times as large as that of the conventional thermoelectric material such as $Bi_2Te_3$ or the like.

The same result as described above was obtained when the other bismuth compound such as bismuth trichloride or the like was used as an intercalant material in the above process.

The same result as described above was obtained when the other hydrocarbon compound such as propane or the like was used as a graphite material in the above process. When a hydrocarbon compound having a molecular amount of 100 or below is used, a suitable supply amount of hydrocarbon compound for preparing a graphite intercalation compound having a bismuth layer between each adjacent graphite layers is preferably about 0.5 to 2 mols to 1 mol of triphenyl bismuth under the following conditions:

| | |
|---|---|
| Temperature at high-temperature furnace: | 900 to 1600 ° C (preferably 1000 to 1200 ° C) |
| Temperature at low-temperature furnace: | 600 to 900 ° C (preferably 700 to 900 ° C) |

The effective supply amount of hydrocarbon compound suitable for preparing a graphite intercalation compound having the bismuth layer between every two graphite layers is 2.0 to 5.0 mols to 1 mol of triphenyl bismuth.

This process can employ other inert gas such as nitrogen, helium or the like instead of argon gas.

When silanes such as tetramethoxy silane ($Si(OCH_3)_4$), tetraethoxy silane ($Si(OC_2H_5)_4$), silane ($SiH_4$), triphenyl silane ($(C_6H_5)_3SiH$), triphenyl chlorosilane ($(C_6H_5)_3SiCl$), trimethyl chlorosilane ($(C_2H_5)_3SiCl$), trimethyl bromosilane ($(CH_3)_3SiBr$), triethyl silane ($(C_2H_5)_3SiH$), triehtyl chlorosilane ($(C_2H_5)_3SiCl$), tetramethylsilane ($(CH_3)_4Si$), disilane ($Si_2H_6$) or the like were used as an intercalant material in the above process, silicon atoms could be intercalated between the graphite layers. Further, germanium atoms could be intercalated between the graphite layers by using organic metal compound such as germanium ($GeH_4$) or the like as an intercalant material.

The same result was obtained in the above process when the other hydrocarbon compounds such as propane or the like was used as a graphite material. When a hydrocarbon compound having a molecular amount of 100 or below is used, a supply amount of hydrocarbon compound is preferably about 0.5 to 7 mols, and more preferably about 0.5 to 4 mols, to 1 mol of the intercalant material under the following conditions:

| | |
|---|---|
| Temperature at high-temperature furnace: | 900 to 1600 ° C (preferably 1000 to 1300 ° C) |
| Temperature at low-temperature furnace: | 600 to 900 ° C (preferably 800 to 900 ° C) |

Comparative Example 4

Various processes have been conventionally developed for intercalating an intercalant between graphite layers to prepare a graphite intercalation compound. Further, various graphite intercalants or compounds having various intercalants intercalated between graphite layers have been prepared by these processes. Examples of the well-known processes include (1) vapor phase reaction process (two-bulb process), (2) a solvent process, (3) an electrochemical process, (4) a mixing process and (5) a pressure applying process disclosed in "Tanso", Vol. III, pp.171 (1982) published by "Tansozairyo-Gakkai". The intercalants known so far range over about 300 kinds including (1) alkali metals such as Li, Na, K, Rb, Cs or the like, (2) alkaline earth metals such as Mg, Ca, Sr or the like, (3) halogen gases such as chlorine, bromine or the like, (4) halides such as ICl or the like, (5) metal halides such as $SbCl_5$, $SbF_5$, $AlCl_3$, $FeCl_3$, $CuCl_2$ or the like, (6) acids such as nitric acid, sulfuric acid, $AsF_5$ or the like, (7) intermetallic compounds such as alkali metal-mercury, mercury-bismuth or the like [see Advances in Physics, 30, 139 (1981)]. However, there have been no examples having an intercalant of Se, Te, Bi, Ge, Si or oxides of Fe or Cu according to the present invention. The intercalation of these intercalants of the present invention was carried out in accordance with the above-mentioned process, resulting in failure.

Comparative Example 5

The number of intercalants which can be intercalated between the graphite layers in the vapor phase reaction process (two-bulb process) mentioned in Comparative Example 4 has been increased because of the discovery of various catalysts. For example, there have been some reports saying that chlorides such as $SiCl_4$ which were reported not to be intercalated can be intercalated by using chlorine gas as a catalyst, or that fluorine, which was covalently bonded to carbon to afford only a graphite fluoride, can be intercalated between graphite layers by using AgF, $WF_6$ or $SbF_5$ as a catalyst. However, the intercalants of the present invention could not be intercalated in accordance with the vapor phase reaction process even by using a catalyst such as chlorine gas, AgF, $WF_6$ or the like..

Comparative Example 6

The preparation of a graphite intercalation compound having the following intercalants intercalated between the graphite layers has been reported, although it has not been concluded to be accurate from the research and review conducted by many scientists. For example, a graphite intercalation compound having Ti, Mn, Fe, Co, Cu or Zu intercalated between the graphite layers has been reported to be prepared by reacting a graphite intercalation compound having a potassium intercalant with a transition metal salt in tetrahydrofuran (THF) [see Journal of Chemical Society, Dalton Transaction, 12. 2026-2028 (1979)]. Further, a document of "Carbon", 18, 203-209 (1980) has reported that a graphite intercalation compound having lanthanides such as Sm, Eu, Tm, Yb or the like intercalated between the graphite layers could be obtained by heating a molding of metal particles of the lanthanides and graphite, and subjecting the resultant molding to solid phase reaction. Moreover, a graphite intercalation compound having a transition metal such as Fe, Co, Ni, Mn, Cu or Mo intercalated between the graphite layers has been reported to be obtained by reducing chlorides of the above element [see Journal of the American Chemical Society, 97. 3366-3373 (1975)]. However, the elements such as Se, Te, Bi, Ge, or Si or oxides of Fe or Cu according to the present invention could not be intercalated in accordance with the above-mentioned conventional methods.

Table 1

| | Com.Ex. 1 | Ex. 1 |
|---|---|---|
| Carrier gas | A r | A r |
| Material gas | propane | propane |
| Supply rate (mol/h) | 4.0 | 4.0 |
| Molecular density (mol/$\ell$) | $2.0 \times 10^{22}$ | $2.0 \times 10^{22}$ |
| Flow rate (cm/min.) | 23 | 23 |
| Decomposition temperature($^\circ$C) | Same as substrate | 1000 or 1200 |
| Substrate temperature($^\circ$C) | 500<br>600<br>700<br>800<br>900<br>1000<br>1100<br>1200 | 400<br>500<br>600<br>700<br>800<br>900<br>1000 |
| Substrate | N i | |

## Table.2

| | Com.Ex. 2 | Ex. 2 | Com.Ex. 3 | Ex. 3 |
|---|---|---|---|---|
| Carrier gas | A r | A r | A r | A r |
| Material gas | benzene | benzene | propane | propane |
| Supply rate (mol/h) | 0.8 | 0.8 | 1.1 | 1.1 |
| Molecular density (mol/$\ell$) | $6.2 \times 10^{21}$ | $6.2 \times 10^{21}$ | $6.2 \times 10^{21}$ | $6.2 \times 10^{21}$ |
| Flow rate (cm/min.) | 15 | 15 | 18.5 | 18.5 |
| Decomposition temperature($^\circ$C) | Same as substrate | 1100 | Same as substrate | 1000 |
| Substrate temperature($^\circ$C) | 500 600 700 800 900 1000 1100 | 500 600 700 800 900 1000 1100 | 500 600 700 800 900 1000 | 500 600 700 800 900 1000 |
| Substrate | N i | | | |

EP 0 500 359 B1

table 3

| | | Com.Ex. 2 | Ex. 2 | Com.Ex. 3 | Ex. 3 |
|---|---|---|---|---|---|
| Material | | benzene | benzene | propane | propane |
| Decomposition temperature(℃) | | Same as substrate | 1100 | Same as substrate | 1000 |
| | | Interplanar spacing of graphite (002) ( Å ) | | | |
| Substrate temperature (℃) | 500 | 3.96 | 3.59 | 4.00 | 3.61 |
| | 600 | 3.90 | 3.56 | 3.92 | 3.57 |
| | 700 | 3.84 | 3.52 | 3.81 | 3.52 |
| | 800 | 3.68 | 3.48 | 3.58 | 3.48 |
| | 900 | 3.48 | 3.44 | 3.43 | 3.43 |
| | 1000 | 3.41 | 3.41 | 3.39 | 3.39 |
| | 1100 | 3.38 | 3.38 | | |

EP 0 500 359 B1

Table 4

| Intercalant material | Intercalant | Temp. for evaporation (°C) | Supply rate of benzene (mol/hr) | Supply rate of intercalant material (mol/hr) | Temp. of high-temp. furnance (°C) | Temp. of low-temp. furnance (°C) |
|---|---|---|---|---|---|---|
| $BiF_3$gas | $BiF_3$ | 750 | 0.22 | 0.18 | 900 | 830 |
| $SeO_2$gas | $SeO_2$ | 400 | 0.056 | 0.048 | 800 | 600 |
| $TeO_2$gas | $TeO_2$ | 480 | 0.19 | 0.12 | 750 | 620 |

EP 0 500 359 B1

Table 5

| Intercalant material | Intercalant | Temp. for evaporation (℃) | Supply rate of dichloro-ethylene (mol/hr) | Supply rate of intercalant material (mol/hr) | Temp. of high-temp. furnance (℃) | Temp. of low-temp. furnance (℃) |
|---|---|---|---|---|---|---|
| $GeCl_4$ gas | $GeCl_4$ | 25 | 0.35 | 0.12 | 450 | 400 |
| $SiCl_4$ gas | $SiCl_4$ | 25 | 0.42 | 0.18 | 450 | 350 |
| $TeCl_4$ gas | $TeCl_4$ | 250 | 0.18 | 0.09 | 560 | 450 |
| $BiBr_3$ gas | $BiBr_3$ | 220 | 0.18 | 0.09 | 560 | 420 |
| $GeBr_4$ gas | $GeBr_4$ | 50 | 0.42 | 0.17 | 400 | 350 |
| $SeBr_4$ gas | $SeBr_4$ | 100 | 0.60 | 0.30 | 400 | 350 |
| $SiBr_4$ gas | $SiBr_4$ | 25 | 0.12 | 0.40 | 400 | 320 |
| $BiI_3$ gas | $BiI_3$ | 450 | 0.32 | 0.10 | 600 | 500 |
| $GeI_4$ gas | $GeI_4$ | 180 | 0.56 | 0.19 | 550 | 350 |
| $SeI_4$ gas | $SeI_4$ | 120 | 0.25 | 0.09 | 400 | 350 |

Table 6

| Intercalant material | Intercalant | Temp. for evaporation (°C) | Supply rate of benzene (mol/hr) | Supply rate of intercalant material (mol/hr) | Temp. of high-temp. furnance (°C) | Temp. of low-temp. furnance (°C) |
|---|---|---|---|---|---|---|
| Fegas | Fe | 2200 | 0.05 | 0.04 | 1300 | 900 |
| Cugas | Cu | 1500 | 0.08 | 0.07 | 1200 | 900 |
| Gegas | Ge | 1200 | 0.10 | 0.095 | 1100 | 900 |
| Bigas | Bi | 1100 | 0.10 | 0.08 | 1000 | 800 |
| Sigas | Si | 1800 | 0.09 | 0.08 | 1250 | 900 |
| Bi$_2$O$_3$gas | Bi$_2$O$_3$ | 1100 | 0.11 | 0.12 | 1200 | 900 |
| Cu$_2$Ogas | Cu$_2$O | 1400 | 0.11 | 0.11 | 1200 | 900 |
| CuOgas | CuO | 1200 | 0.23 | 0.21 | 1500 | 900 |
| FeOgas | FeO | 1600 | 0.19 | 0.18 | 1500 | 900 |
| Fe$_3$O$_4$gas | Fe$_3$O$_4$ | 1800 | 0.40 | 0.40 | 1500 | 900 |
| Fe$_2$O$_3$gas | Fe$_2$O$_3$ | 1800 | 0.20 | 0.20 | 1500 | 1000 |
| GeOgas | GeO | 1000 | 0.80 | 0.80 | 1000 | 800 |
| GeO$_2$gas | GeO$_2$ | 1400 | 0.90 | 0.72 | 1300 | 900 |
| SiO$_2$gas | SiO$_2$ | 1600 | 0.10 | 0.08 | 1400 | 900 |

**Claims**

1.  A process for preparing graphite-structure carbon and intercalation compounds thereof, the process being carried out in a device comprising
      a decomposition zone A for decomposing a hydrocarbon gas;

a product growing zone B where a substrate (6,16,36) is disposed; and
an optional gas generating zone C for generating gas of an intercalant,
by maintaining a temperature in zone B at least more than 50°C lower than that in zone A and allowing a graphite-structure carbon or an intercalation compound thereof to grow on the substrate.

2. A process according to claim 1, wherein the temperature in zone B is maintained at least more than 100°C lower than that in zone A.

3. A process according to claim 1 or claim 2 for preparing a graphite-structural carbon, wherein the temperature in zone A is within the range of 850°C to 1300°C and the temperature in zone B is within the range of 400°C to 750°C.

4. A process according to claim 1 or claim 2 for preparing a graphite-structure carbon intercalation compound, wherein the temperature in zone A is within the range of 300°C to 1600°C and the temperature in zone B is within the range of 300°C to 1100°C.

5. A process according to claim 4, wherein the temperature in zone A is within the range of 400°C to 1500°C and the temperature in zone B is within the range of 350°C to 1000°C.

6. A process according to any one of claims 1, 2, 4 and 5, wherein the starting material for the intercalant gas is selected from selenium, tellurium, bismuth, germanium, silicon and halides and organic compounds thereof.

7. A process according to any one of claims 1, 2, 4 and 5, wherein the starting material for the intercalant gas is selected from iron and copper and oxides thereof.

8. A graphite intercalation compound having a graphite carbon structure comprising intercalated between each adjacent or every two graphite layers, an intercalant having a thermoelectric power of 150 $\mu$V/K or more.

9. A graphite intercalation compound according to claim 8, wherein the intercalant is selected from selenium, tellurium, bismuth, germanium, silicon, and oxides thereof.

10. A graphite intercalation compound according to claim 8, wherein the intercalant is selected from iron oxides and copper oxides.

**Patentansprüche**

1. Verfahren zur Herstellung eines Kohlenstoffes mit Graphitstruktur und von Interkalationsverbindungen davon, wobei das Verfahren in einer Vorrichtung durchgeführt wird, umfassend
eine Zersetzungszone A zum Zersetzen eines Kohlenwasserstoffgases;
eine Produktwachstumszone B, worin ein Substrat (6, 16, 36) disponiert ist; und
eine wahlweise Gaserzeugungszone C zum Erzeugen eines Gases aus einem Interkalationsmittel,
wobei eine Temperatur in der Zone B um zumindest mehr als 50°C niedriger als die in der Zone A gehalten wird und wobei ein Kohlenstoff mit Graphitstruktur oder eine Interkalationsverbindung davon auf dem Substrat wachsen gelassen wird.

2. Verfahren nach Anspruch 1, worin die Temperatur in Zone B um zumindest mehr als 100°C niedriger als die in der Zone A gehalten wird.

3. Verfahren nach Anspruch 1 oder Anspruch 2 zur Herstellung eines Kohlenstoffes mit Graphitstruktur, worin die Temperatur in Zone A innerhalb des Bereiches von 850°C bis 1300°C und die Temperatur in Zone B innerhalb des Bereiches von 400°C bis 750°C ist.

4. Verfahren nach Anspruch 1 oder Anspruch 2 zur Herstellung einer Interkalationsverbindung aus Kohlenstoff mit Graphitstruktur, worin die Temperatur in Zone A innerhalb des Bereiches von 300°C bis 1600°C und die Temperatur in Zone B innerhalb des Bereiches von 300°C bis 1100°C liegt.

5. Verfahren nach Anspruch 4, worin die Temperatur in Zone A innerhalb des Bereiches von 400°C bis 1500°C und die Temperatur in Zone B innerhalb des Bereiches von 350°C bis 1000°C liegt.

6. Verfahren nach einem der Ansprüche 1, 2, 4 und 5, worin das Ausgangsmaterial für das Interkalationsgas ausgewählt ist aus Selen, Tellur, Wismut, Germanium, Silicium und Halogeniden und organischen Verbindungen davon.

7. Verfahren nach einem der Ansprüche 1, 2, 4 und 5, worin das Ausgangsmaterial für das Interkalationsgas aus Eisen und Kupfer und Oxiden davon ausgewählt ist.

8. Graphit-Interkalationsverbindung mit einer Graphit-Kohlenwasserstoffstruktur, umfassend eingeschoben zwischen jeder benachbarten oder allen zwei Graphitschichten ein Interkalationsmittel mit einer thermo-elektrischen Leistung von 150 $\mu$V/K oder mehr.

9. Graphit-Interkalationsverbindung nach Anspruch 8, worin das Interkalationsmittel ausgewählt ist aus Selen, Tellur, Wismut, Germanium, Silicium und Oxiden davon.

10. Graphit-Interkalationsverbindung nach Anspruch 8, worin das Interkalationsmittel ausgewählt ist aus Eisenoxiden und Kupferoxiden.

**Revendications**

1. Procédé pour préparer un carbone à structure graphitique et des composés d'intercalation de celui-ci, le procédé étant réalisé dans un dispositif comprenant
   une zone A de décomposition pour la décomposition d'un gaz hydrocarboné ;
   une zone B de croissance de produit dans laquelle un substrat (6, 16, 36) est disposé ; et
   une zone facultative C de production de gaz pour produire un gaz d'un intercalant,
   par maintien dans la zone B d'une température inférieure de plus de 50°C au moins à celle dans la zone A et en laissant un carbone à structure graphitique ou un composé d'intercalation de celui-ci croître sur le substrat.

2. Procédé selon la revendication 1, dans lequel la température dans la zone B est maintenue à une valeur inférieure de plus de 100°C au moins à celle dans la zone A.

3. Procédé selon la revendication 1 ou la revendication 2, pour préparer un carbone à structure graphitique dans lequel la température dans la zone A est dans la gamme de 850°C à 1 300°C et la température dans la zone B est dans la gamme de 400°C à 750°C.

4. Procédé selon la revendication 1 ou la revendication 2, pour préparer un composé d'intercalation de carbone à structure graphitique dans lequel la température dans la zone A est dans la gamme de 300°C à 1 600°C et la température dans la zone B est dans la gamme de 300°C à 1 100°C.

5. Procédé selon la revendication 4, dans lequel la température dans la zone A est dans la gamme de 400°C à 1 500°C et la température dans la zone B est dans la gamme de 350°C à 1 000°C.

6. Procédé selon l'une quelconque des revendications 1, 2, 4 et 5, dans lequel la matière de départ du gaz intercalant est choisie parmi le sélénium, le tellure, le bismuth, le germanium, le silicium et leurs halogénures et derivés organiques.

7. Procédé selon l'une quelconque des revendications 1, 2, 4 et 5, dans lequel la matière de départ du gaz intercalant est choisie parmi le fer, le cuivre et leurs oxydes.

8. Composé d'intercalation du graphite, ayant une structure de carbone graphitique, comprenant, intercalé entre chaque couche de graphite adjacente ou entre chaque ensemble de deux couches de graphite, un intercalant ayant un pouvoir thermoélectrique de 150 $\mu$V/K ou plus.

9. Composé d'intercalation du graphite selon la revendication 8, dans lequel l'intercalant est choisi parmi le sélénium, le tellure, le bismuth, le germanium, le silicium et leurs oxydes.

**10.** Composé d'intercalation du graphite selon la revendication 8, dans lequel l'intercalant est choisi parmi les oxydes de fer et les oxydes de cuivre.

FIG.1

C   A   B

8   4   5   9   62

1   2

3   4   5   7   6

FIG.2

C   A   B

23   18   13   14   15   19   62

20   21   22   10

11   12

14   15   17   16

FIG.3

C    A    B

43  38  33    34    35    39  62

41

31

40

42

32

34    35    37  36

FIG.4

54  52  51    57

59

60

61    53    55    58

56

## FIG. 5

SUBSTRATE TEMPERATURE ( °C )

FIG.6